# EUROPEAN PATENT APPLICATION

(11) **EP 4 794 195 A1**
(43) Date of publication of application: **19.08.2026**
(21) Application number: 24882711.5
(22) Date of filing: 14.10.2024
(51) Int. Cl.: H03F 1/02, H03F 1/56, H03F 3/21, H03F 3/60

(54) **DOHERTY POWER AMPLIFIER AND ELECTRONIC DEVICE COMPRISING SAME**

(30) Priority: 27.10.2023 KR 20230146118
(71) Applicant: Samsung Electronics Co., Ltd., Suwon-si, Gyeonggi-do 16677 (KR)
(72) Inventor: KANG, Hyunuk, Suwon-si Gyeonggi-do 16677 (KR); KIM, Kyoungtae, Suwon-si Gyeonggi-do 16677 (KR); KIM, Changwook, Suwon-si Gyeonggi-do 16677 (KR); OH, Sungjae, Suwon-si Gyeonggi-do 16677 (KR); WOO, Youngyoon, Suwon-si Gyeonggi-do 16677 (KR); JEE, Seunghoon, Suwon-si Gyeonggi-do 16677 (KR)
(74) Representative: Gulde & Partner
(86) International application number: PCT/KR2024/015458
(87) International publication number: WO 2025/089684

(57) **Abstract**

In embodiments, a two-stage Doherty power amplifier is provided. The two-stage Doherty power amplifier may comprise: a drive amplification circuit; a Doherty amplification circuit including a carrier amplifier and a peaking amplifier; and a network circuit arranged between the drive amplification circuit and the Doherty amplification circuit. The network circuit may comprise: an output matching circuit for the drive amplification circuit; a power distribution circuit for distributing an output of the drive amplification circuit to each of the carrier amplifier and the peaking amplifier; a first input matching circuit for the carrier amplifier; and a second input matching circuit for the peaking amplifier. The power distribution circuit may be configured to provide a phase difference of a specified magnitude in a first direction. Each of the first input matching circuit and the second input matching circuit may be configured to provide the phase difference of the specified magnitude in a second direction opposite to the first direction.

## Description

### [Technical Field]

The present disclosure relates to a Doherty power amplifier and an electronic device including the Doherty power amplifier.

### [Background Art]

Products equipped with a plurality of antennas are being developed to increase communication performance. As the number of antennas increases, the number of RF components (e.g., a power amplifier (PA)) for processing a signal received through an antenna or radiated through an antenna also increases.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

In embodiments of the present disclosure, a dual stage Doherty power amplifier is provided. The dual stage Doherty power amplifier may comprise a drive amplification circuit, a Doherty amplification circuit including a carrier amplifier and a peaking amplifier, and a network circuit disposed between the drive amplification circuit and the Doherty amplification circuit. The network circuit may include an output matching circuit for the drive amplifier circuit, a power distribution circuit for distributing the output of the drive amplifier circuit to each of the carrier amplifier and the peaking amplifier, a first input matching circuit for the carrier amplifier, and a second input matching circuit for the peaking amplifier. The power distribution circuit may be configured to provide a phase difference of a specified magnitude in a first direction. Each of the first input matching circuit and the second input matching circuit may be configured to provide a phase difference of the specified magnitude in a second direction opposite to the first direction.

In embodiments of the present disclosure, an electronic device including a dual stage Doherty power amplifier is provided. The electronic device may comprise a plurality of antennas, a plurality of filters for the plurality of antennas, a plurality of radio frequency (RF) processing circuits for the plurality of antennas, and a processor. Each RF processing circuit of the plurality of RF processing circuits may include the dual stage Doherty power amplifier. The dual stage Doherty power amplifier may include a drive amplification circuit, a Doherty amplification circuit including a carrier amplifier and a peaking amplifier, and a network circuit disposed between the drive amplification circuit and the Doherty amplification circuit. The network circuit may include an output matching circuit for the drive amplifier circuit, a power distribution circuit for distributing the output of the drive amplifier circuit to each of the carrier amplifier and the peaking amplifier, a first input matching circuit for the carrier amplifier, and a second input matching circuit for the peaking amplifier. The power distribution circuit may be configured to provide a phase difference of a specified magnitude in a first direction. Each of the first input matching circuit and the second input matching circuit may be configured to provide a phase difference of the specified magnitude in a second direction opposite to the first direction.

### [Description of the Drawings]

FIG. 1 illustrates a wireless communication system.
FIG. 2A illustrates an example of network entities of an electronic device.
FIG. 2B illustrates an example of an electronic device including a Doherty power amplifier (PA).
FIG. 2C illustrates another example of an electronic device including a Doherty power amplifier.
FIG. 3 illustrates an example of a dual stage Doherty power amplifier.
FIG. 4 illustrates an example of components of a network circuit of a dual stage Doherty power amplifier.
FIGS. 5A to 5C illustrate examples of network circuits of a dual stage Doherty power amplifier.
FIG. 6 illustrates another example of a network circuit of a dual stage Doherty power amplifier.
FIG. 7 illustrates examples of a smith chart of a dual stage Doherty power amplifier.
FIGS. 8A and 8B illustrate examples of performance of a dual stage Doherty power amplifier.
FIG. 9 illustrates an example of components of a dual stage Doherty power amplifier.
FIG. 10 illustrates an example of components of an electronic device.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

Terms for referring to a signal (e.g., signal, information, message, signaling), terms for referring to network entities (e.g., electronic device, unit, RU, DU, CU, module, communication module, RF unit, RF module, RF circuit), terms for referring to a component of a device, terms for referring to a component of an electronic device (e.g., substrate, print circuit board (PCB), flexible PCB (FPCB), module, antenna, antenna element, circuit, processor, chip, component, device), terms for referring to a circuit (e.g., PCB, FPCB, signal line, feeding line, data line, RF signal line, antenna line, RF path, RF module, RF circuit, splitter, divider, coupler, combiner), and the like used in the following description are exemplified for convenience of description. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

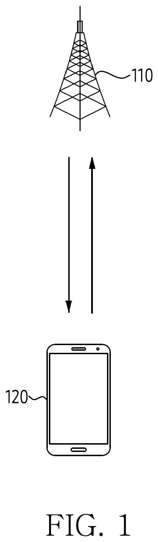

FIG. 1 illustrates a wireless communication system.

Referring to FIG. 1, FIG. 1 illustrates a base station 110 and a terminal 120 as a portion of nodes that utilize a wireless channel in a wireless communication system. FIG. 1 illustrates only one base station, but a wireless communication system may further include another base station that is identical or similar to the base station 110.

The base station 110 is a network infrastructure that provides wireless access to the terminal 120. The base station 110 has coverage defined based on a distance at which a signal may be transmitted. In addition to 'base station', the base station 110 may be referred to as an 'access point (AP)', 'eNodeB (eNB)', '5th generation node', 'next generation nodeB (gNB)', 'wireless point', 'transmission/reception point (TRP)' or other terms having equivalent technical meanings.

The terminal 120, which is a device used by a user, performs communication with the base station 110 through a wireless channel. A link from the base station 110 to the terminal 120 is referred to as a downlink (DL), and a link from the terminal 120 to the base station 110 is referred to as an uplink (UL). In addition, although not illustrated in FIG. 1, the terminal 120 and another terminal may perform communication with each other through a wireless channel. At this time, a link (device-to-device link (D2D)) between the terminal 120 and the other terminal is referred to as a sidelink, and the sidelink may be used interchangeably with a PC5 interface. In some other embodiments, the terminal 120 may be operated without the user's involvement. According to an embodiment, the terminal 120, which is a device performing machine type communication (MTC), may not be carried by the user. Additionally, according to an embodiment, the terminal 120 may be a narrowband (NB)-internet of things (IoT) device. In addition to 'terminal', the terminal 120 may also be referred to as 'user equipment (UE) ', 'customer premises equipment, (CPE) ', 'mobile station', 'subscriber station', 'remote terminal', 'wireless terminal', 'electronic device', 'user device', or other terms having equivalent technical meanings.

The base station 110 may transmit a signal to the terminal 120. The terminal 120 may receive a signal from the base station 110. According to an embodiment, a circuit including a Doherty power amplifier according to embodiments of the present disclosure may be included in the base station 110. The terminal 120 may transmit a signal to the base station 110. The base station 110 may receive a signal from the terminal 120. According to an embodiment, a circuit including a Doherty power amplifier according to embodiments of the present disclosure may be included in the terminal 120. For example, the base station 110 and the terminal 120 may transmit and receive a wireless signal in a relatively low frequency band (e.g., frequency range 1 (FR 1) of NR). In addition, for example, the base station 110 and the terminal 120 may transmit and receive a wireless signal in a relatively high frequency band (e.g., FR 2 (or FR 2-1, FR 2-2, and FR 2-3), FR 3 of NR, or a millimeter wave (mmWave) band (e.g., 28GHz, 30GHz, 38GHz, and 60GHz)). In order to improve a channel gain, the base station 110 and the terminal 120 may perform beamforming. Here, the beamforming may include transmission beamforming and reception beamforming. The base station 110 and the terminal 120 may provide directivity to a transmission signal or a reception signal. To this end, the base station 110 and the terminal 120 may select serving beams through a beam search or beam management procedure. After the serving beams are selected, subsequent communication may be performed through a resource in a QCL relationship with a resource that has transmitted the serving beams.

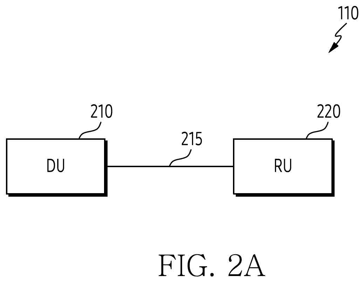

In a communication system in which a cell radius of a base station is relatively large, each base station is installed to include functions of a digital processing unit (or distributed unit (DU)) and a radio frequency (RF) processing unit (or radio unit (RU)). However, as a high frequency band is used and cell coverage of the base station becomes small in a 4th generation (4G) and/or a subsequent communication system (e.g., 5G), the number of base stations for covering a specific area increased. Installation cost burden of an operator for installing the base stations also increased. In order to minimize the installation cost of the base station, a structure in which the DU and the RU (or massive MIMO unit (MMU)) of the base station are separated and one or more RUs are connected to one DU through a wired network, and one or more RUs distributed geographically to cover the specific area are disposed are proposed. Hereinafter, an arrangement structure and expansion examples of a base station according to various embodiments of the present disclosure are described through FIG. 2A.

FIG. 2A illustrates an example of network entities of an electronic device. For example, the electronic device may include the base station 110 of FIG. 1. The base station 110 may be separated into two or more entities through a fronthaul. Unlike a backhaul, the fronthaul refers to an interface between a DU and an RU between a wireless network and a core network. In FIG. 2A, an example of a fronthaul structure between the DU and one RU is illustrated, but this is merely for convenience of description, and the present disclosure is not limited thereto. In other words, an embodiment of the present disclosure may also be applied to a fronthaul structure between one DU and a plurality of RUs. For example, the embodiment of the present disclosure may be applied to a fronthaul structure between one DU and two RUs. In addition, the embodiment of the present disclosure may also be applied to a fronthaul structure between one DU and three RUs.

Referring to FIG. 2A, the base station 110 may include a DU 210 and an RU 220. A fronthaul 215 between the DU 210 and the RU 220 may be operated through an Fx interface. For example, for operation of the fronthaul 215, an interface such as common public radio interface (CPRI), enhanced common public radio interface (eCPRI), radio over ethernet (ROE) may be used.

As communication technology develops, mobile data traffic increases, and accordingly, a bandwidth requirement required in a fronthaul between a digital unit and a radio unit significantly increases. In an arrangement such as a centralized/cloud radio access network (C-RAN), the DU 210 may be implemented to perform functions for a packet data convergence protocol (PDCP), a radio link control (RLC), a media access control (MAC), a physical (PHY), and the RU 220 may be implemented to further perform functions for a PHY layer in addition to a radio frequency (RF) function.

The DU 210 may be responsible for a high layer function of a wireless network. For example, the DU 210 may perform a function of the MAC layer, a part of the PHY layer. Here, the part of the PHY layer is performed at a higher stage among the functions of the PHY layer, and as an example, may include channel encoding (or channel decoding), scrambling (or descrambling), modulation (or demodulation), layer mapping (or layer demapping). According to an embodiment, in a case that the DU 210 follows an O-RAN standard, the DU 210 may be referred to as an O-RAN DU (O-DU). The DU 210 may be represented by being replaced with a first network entity for a base station (e.g., gNB) in embodiments of the present disclosure as necessary.

The RU 220 may be responsible for a low layer function of a wireless network. For example, the RU 220 may perform a part of a PHY layer, an RF function. Here, the part of the PHY layer is performed at a relatively lower stage than the DU 210 among the functions of the PHY layer, and as an example, may include iFFT conversion (or FFT conversion), CP insertion (CP removal), and digital beamforming. The RU 220 may be referred to as an access unit (AU), an access point (AP), a transmission/reception point (TRP), a remote radio head (RRH), a radio unit (RU) or another term having an equivalent technical meaning. According to an embodiment, in a case that the RU 220 follows an O-RAN standard, the RU 220 may be referred to as an O-RAN RU (O-RU). The RU 220 may be represented by being replaced with a second network entity for a base station (e.g., gNB) in embodiments of the present disclosure as necessary. According to an embodiment, a circuit including a Doherty power amplifier may be included in the RU 220 of the base station 110 having a distributed arrangement.

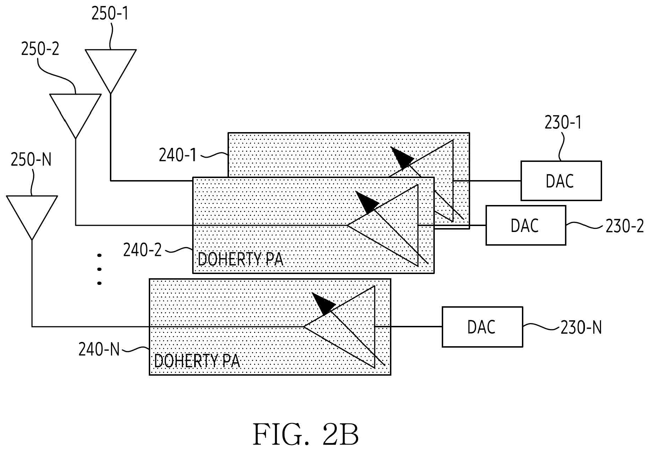

FIG. 2B illustrates an example of an electronic device (e.g., the base station 110, the terminal 120, the RU 220) including a Doherty power amplifier (PA). An example of an electronic device including a power amplifier (PA) is illustrated. For example, the electronic device may be the base station 110. For example, the device may be the RU 220.

Referring to FIG. 2B, an electronic device may include a plurality of antennas 250-1, 250-2, ..., and 250-N (N is an integer of 2 or more). The electronic device may include an RF processing circuit to transmit a wireless signal. In order for signals to be radiated through the plurality of antennas, the RF processing circuit may include a plurality of RF paths. The electronic device may include an up converter for up-converting a digital transmission signal of a base band to a transmission frequency, and a digital-to-analog converter (DAC) for converting the up-converted digital transmission signal into an analog RF transmission signal. For example, the electronic device may include a DAC for each RF path. The electronic device may include DACs 230-1, 230-2, ..., and 230-N.

Since a transmission signal of a base station or a terminal is transferred through a wireless channel in a wireless communication system, it undergoes severe attenuation. To this end, the electronic device may be configured to include an amplifier for amplification of the transmission signal. For amplification of a signal transferred to air, a power amplifier may be disposed in an RF path. According to embodiments of the present disclosure, the electronic device may include a Doherty power amplifier. For example, a Doherty power amplifier may be disposed in each RF path. The electronic device may include a plurality of Doherty power amplifiers 240-1, 240-2, ..., and 240-N. An analog RF signal outputted through the DAC 230-i may be amplified through a Doherty power amplifier 240-i. The Doherty power amplifier 240-i may amplify an applied signal and transfer the amplified signal to an antenna 250-i.

Beamforming technology is being used as one of technologies for alleviating a propagation path loss and increasing a transfer distance of radio wave. In general, the beamforming concentrates a reach area of a radio wave using a plurality of antennas, or increases directivity of reception sensitivity for a specific direction. Therefore, an electronic device may be provided with a plurality of antennas to form beamforming coverage instead of forming a signal in an isotropic pattern using a single antenna. According to an embodiment, the electronic device may include a massive MIMO unit (MMU). A form in which a plurality of antennas are assembled may be referred to as an antenna array, and each antenna included in the array may be referred to as an array element, or an antenna element. The antenna array may be configured in various forms such as a linear array, a planar array, and the like. The antenna array may be referred to as a massive antenna array.

For higher data capacity, the number of RF paths should increase or power per RF path should increase. Increasing the RF paths results in a larger product size, and a spatial constraint exists in actually installing base station equipment. To increase an antenna gain through high output without increasing the number of the RF paths, a plurality of antenna elements may be connected to one RF path using a divider (or splitter) in the RF path. As a signal is radiated through the plurality of antenna elements, the antenna gain may increase. Antenna elements corresponding to the RF path may be referred to as a sub-array.

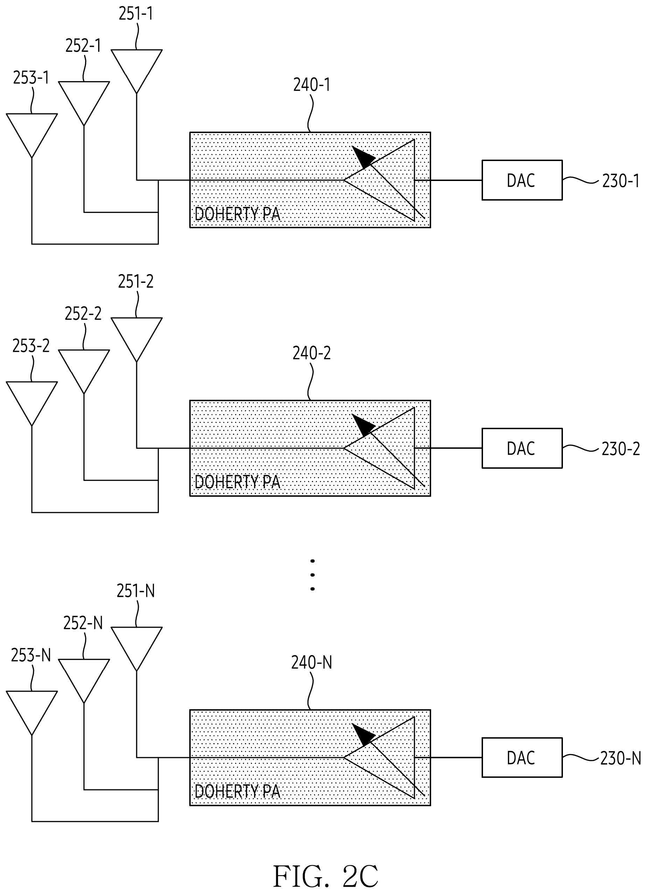

FIG. 2C illustrates another example of an electronic device (e.g., the base station 110, the terminal 120, the RU 220) including a Doherty power amplifier. For example, the electronic device may be the base station 110. For example, the device may be the RU 220. The electronic device may transmit and/or receive a signal using the above-described sub-array. Hereinafter, in FIG. 2C, a 3x1 sub-array is described as an example.

Referring to FIG. 2C, the electronic device may include a plurality of antennas. The plurality of antennas may be distributed in units of sub-arrays. The sub-array may include a plurality of antenna elements. For example, a first sub-array of the electronic device may include antenna elements 251-1, 251-2, and 251-3. A second sub-array of the electronic device may include antenna elements 252-1, 252-2, and 252-3. In this manner, an N-th sub-array of the electronic device may include antenna elements 251-N, 251-N, and 251-N. The electronic device may include an RF processing circuit to transmit a wireless signal. In order for signals to be radiated through a plurality of antennas, the RF processing circuit may include a plurality of RF paths. For example, the electronic device may include a DAC for each RF path. The electronic device may include DACs 230-1, 230-2, ..., and 230-N.

Each RF path may be connected to a sub-array. A sub-array technology refers to a technology for increasing a gain of a corresponding signal by dividing and feeding a fed signal to a plurality of antenna elements. The electronic device may include a Doherty power amplifier. For example, a Doherty power amplifier may be disposed in each RF path. The electronic device may include a plurality of Doherty power amplifiers 240-1, 240-2, ..., and 240-N. An analog RF signal outputted through a DAC 230-i may be amplified through a Doherty power amplifier 240-i. The Doherty power amplifier 240-i may amplify an applied signal and transfer the amplified signal to antenna elements 251-i, 252-i, and 253-i of a sub-array of a corresponding RF path.

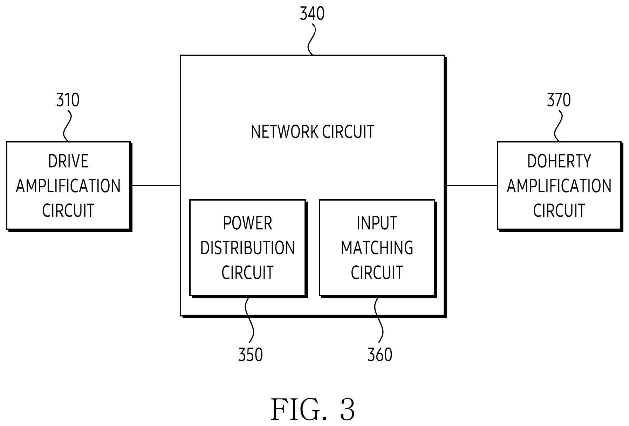

In FIGS. 2B and 2C, an RF path in which a Doherty power amplifier to be proposed through embodiments of the present disclosure is disposed has been described. Meanwhile, the RF path illustrated in FIGS. 2B and 2C is only an embodiment for explaining a transfer process of an RF signal to a power amplifier and an antenna. It is not interpreted as excluding an RF processing circuit having a structure different from the structures illustrated in FIGS. 2B and 2C from the embodiments. In addition, FIGS. 2B and 2C are only examples for explaining an RF path and are not interpreted as limiting an implementation method of the Doherty power amplifier of the present disclosure. For example, a circuit including the Doherty power amplifier may be disposed on a substrate (e.g., PCB) in an electronic device (e.g., the base station 110, the terminal 120, the RU 220), or may be implemented as a component (e.g., power amplifier module (PAM), RFIC). As an example, an RFIC (e.g., beamforming RFIC, monolithic microwave integrated circuit (MMIC) MMU RFIC, mmWave RFIC) includes a plurality of RF paths, and each RF path may include a Doherty power amplifier. Hereinafter, exemplary circuits of a Doherty power amplifier according to embodiments are described through FIGS. 3 to 9.

An electronic device supporting wireless communication may consume a large amount of power in an RF transmission terminal. In particular, a power amplifier of the electronic device may consume a large amount of power. Since communication technologies such as long term evolution (LTE) technology or 5G new radio (NR) use an OFDM scheme, a high peak-to-average power ratio (PAPR) may occur. In order to reduce a loss of a peak signal, the power amplifier may be required to operate in a region backed-off by the PAPR from a maximum output power. At this time, efficiency of the power amplifier may decrease. In order to overcome the decreased efficiency, an electronic device according to embodiments of the present disclosure may include a Doherty power amplifier. The Doherty power amplifier may provide high efficiency in a back-off region through a load modulation technique.

An electronic device (e.g., the base station 110, the terminal 120, or a network entity (e.g., RU 220, a repeater) related to the base station 110) according to embodiments of the present disclosure may include a Doherty power amplifier. In the present disclosure, technologies for improving efficiency of a dual stage Doherty power amplifier are described. Through optimization of components in the dual stage Doherty power amplifier, a miniaturized power amplifier providing improved performance may be provided. As the efficiency of the dual stage Doherty power amplifier is improved, power consumption of the electronic device including the dual stage Doherty power amplifier may decrease.

FIG. 3 illustrates an example of a dual stage (or two-stage) Doherty power amplifier (e.g., Doherty power amplifier 240-1, Doherty power amplifier 240-2, ..., and Doherty power amplifier 240-N). The dual stage Doherty power amplifier described below with reference to FIG. 3 exemplifies the Doherty power amplifier of FIGS. 2B and 2C.

Referring to FIG. 3, a dual stage Doherty power amplifier 300 may include a drive amplification circuit 310, a network circuit 340, and a Doherty amplification circuit 370. The Doherty amplification circuit 370, which is a main amplification circuit, may include a Doherty power amplifier. For example, the Doherty amplification circuit 370 may include a carrier amplifier and a peaking amplifier. The carrier amplifier may be referred to as a main amplifier, and the peaking amplifier may be referred to as an auxiliary amplifier. Generally, at low output, the carrier amplifier operates to maintain high efficiency, and at high output, two amplifiers, that is, the carrier amplifier and the peaking amplifier, may operate in parallel. The carrier amplifier may generally be an AB-class (an operating point is shifted to A-class bias) or a B-class (an operating point at a cutoff point of a transistor) amplifier. The peaking amplifier is generally a C-class (an operating point below a cutoff point of a transistor) amplifier, and may form a large amount of distortion. For example, as input power is included, the peaking amplifier may operate. Linearity may be maintained by adjusting a bias such that the formed distortion and distortion of the carrier amplifier cancel each other out. The Doherty amplification circuit 370 may include a structure for connecting the carrier amplifier and the peaking amplifier. For a basic operating principle of the Doherty amplification circuit 370, a load modulation technique or an active load pull technique by an output current of the peaking amplifier may be used. For example, the load modulation technique may provide efficiency improvement in a back-off region as a load impedance is modulated according to output power.

The drive amplification circuit 310 may be used to drive signals to be applied to the carrier amplifier and the peaking amplifier of the Doherty amplification circuit 370. The drive amplification circuit 310 may be connected to the Doherty amplification circuit 370 through the network circuit 340. The network circuit 340 may include a power distribution circuit 350 and an input matching circuit 360. Since the network circuit 340 is disposed between the drive amplification circuit 310 and the Doherty amplification circuit 370, the network circuit 340 may be referred to as an inter-stage network circuit, an inter-network circuit, a connection network circuit, a connection circuit, an inter-stage circuit, and/or an equivalent technical term, in addition to the network circuit.

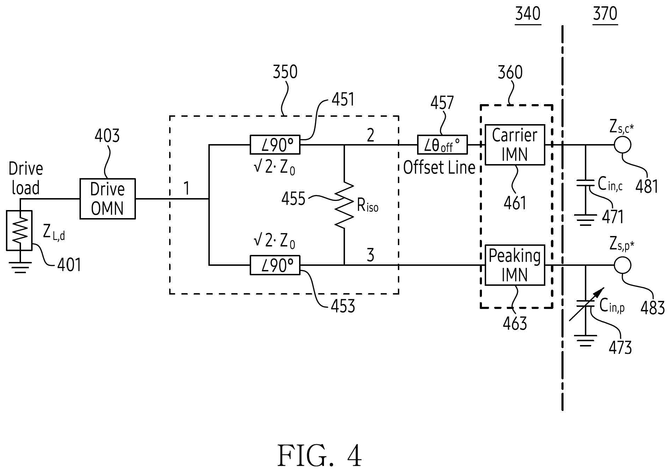

Since the carrier amplifier of the Doherty amplification circuit 370 operates as the AB-class amplifier, an input capacitance of a capacitor of the carrier amplifier may have a constant magnitude according to input power. The peaking amplifier of the Doherty amplification circuit 370 may operate as a C-class amplifier. For example, the peaking amplifier may include a metal oxide semiconductor field effect transistor (MOSFET) amplifier. Due to a characteristic of the C-class amplifier (e.g., a DC operating point below a cutoff point), an input capacitance of a capacitor of the peaking amplifier may have a characteristic of non-linearly increasing according to input power (e.g., power applied to the peaking amplifier). A difference in input capacitance causes a change in impedance. If the network circuit 340 is designed without considering an impedance difference between the carrier amplifier and the peaking amplifier according to output power, a load impedance of the drive amplification circuit 310 may be inversely modulated in an inappropriate direction. The network circuit 340 according to embodiments of the present disclosure may be configured to control the load impedance of the drive amplification circuit 310 based on the impedance difference between the carrier amplifier and the peaking amplifier according to the output power in the dual stage Doherty power amplifier 300. For example, the power distribution circuit 350 may be configured to rotate an input RF signal by a phase of a specified magnitude (e.g., substantially 90 degrees, substantially -90 degrees), and the input matching circuit 360 may be configured to reversely rotate the input RF signal by the phase of the specified magnitude. As not only the load impedance of the Doherty amplification circuit 370 but also the load impedance of the drive amplification circuit 310 is modulated according to the output power, efficiency of the dual stage Doherty power amplifier 300 may be further increased. Hereinafter, specific examples of the network circuit 340 of the dual stage Doherty power amplifier 300 are described through FIGS. 4 to 6.

FIG. 4 illustrates examples of components of a network circuit (e.g., the network circuit 340) of a dual stage Doherty power amplifier (e.g., the dual stage Doherty power amplifier 300).

Referring to FIG. 4, the dual stage Doherty power amplifier 300 may include a Doherty amplification circuit 370. The Doherty amplification circuit 370 may include a carrier amplifier and a peaking amplifier. Since the carrier amplifier operates as the AB-class amplifier, a capacitance (C_{inp, c}) of an input capacitor 471 of the carrier amplifier may have a constant magnitude regardless of input power. Since the peaking amplifier operates as the C-class amplifier, an input capacitor 473 between a gate terminal and a source terminal of the peaking amplifier may be understood as providing a variable capacitance (C_{inp, p}) according to the input power. The network circuit 340 may be connected to an input stage 481 (Z_{s,c}*) of the carrier amplifier and an input stage 483 (Z_{s,p}*) of the peaking amplifier.

Each amplification circuit (e.g., the drive amplification circuit 310 or the Doherty amplification circuit 370) of the dual stage Doherty power amplifier 300 may have a matching network circuit at an input stage and an output stage, respectively. The matching network circuit connected to the input stage may be referred to as an input matching network (IMN) (or an input matching circuit), and the matching network circuit connected to the output stage may be referred to as an output matching network (OMN) (or an output matching circuit). A drive load 401 (Z_{L,d}) may represent the drive amplification circuit 310. The network circuit 340 may include an output matching circuit 403 for the drive amplification circuit 310 and an input matching circuit 360 for the Doherty amplification circuit 370.

The network circuit 340 may include a power distribution circuit 350. The power distribution circuit 350 may be disposed between the output matching circuit 403 and the input matching circuit 360. The power distribution circuit 350 may be configured to distribute power to the carrier amplifier and the peaking amplifier. The power distribution circuit 350 may be configured to distribute power amplified from the drive amplification circuit 310 to each of the carrier amplifier and the peaking amplifier. For example, the power distribution circuit 350 of the network circuit 340 may include a Wilkinson power divider. The power distribution circuit 350 may include a first line 451, a second line 453, and an isolation resistor 455 (Rᵢₛₒ). The first line 451 may provide an impedance of ${\sqrt{2}}_{{Z}_{0}}$ having a phase difference of substantially 90 degrees (Z₀ is a characteristic impedance). The second line 453 may provide an impedance of ${\sqrt{2}}_{{Z}_{0}}$ having a phase difference of substantially 90 degrees. The network circuit 340 may include an offset line 457. The network circuit 340 may include the offset line 457. The offset line 457 may be configured to compensate for a phase difference between an input signal to the carrier amplifier and an input signal to the peaking amplifier, between the power distribution circuit 350 and the input matching circuit 360. The network circuit 340 may include the input matching circuit 360. The input matching circuit 360 may include a first input matching circuit 461 for the carrier amplifier and a second input matching circuit 463 for the peaking amplifier.

For example, the carrier amplifier and the peaking amplifier may be matched at a maximum output power. Accordingly, the power distribution circuit 350, the offset line 457 for phase optimization, and the output matching circuit 403 may be in an impedance-matched state. However, a change in capacitance of the input capacitor 471 of the carrier amplifier and the input capacitor 473 of the peaking amplifier may vary according to input power. As described above, since the carrier amplifier is biased to an AB-class point, the input capacitor 471 of the carrier amplifier has a constant capacitance according to the input power. On the other hand, since the peaking amplifier is biased to a C-class point, the input capacitor 473 of the peaking amplifier has a non-linear capacitance according to the input power. For example, a capacitance value of the input capacitor 473 of the carrier amplifier may increase from a low value to a high value according to output power. Since it is assumed that the carrier amplifier and the peaking amplifier are in a matched state at the maximum output power, at a low output power at which the peaking amplifier is turned off, a circuit of the peaking amplifier may cause mismatch. The mismatch may cause a change in an input impedance of the power distribution circuit 350, and the change may change a load impedance of the drive amplification circuit 310.

In order to resolve the above-described problem, the network circuit 340 according to embodiments of the present disclosure, based on the power distribution circuit 350 and the input matching circuit 360 configured to perform phase rotation of a specified magnitude, the load impedance of the drive amplification circuit 310...

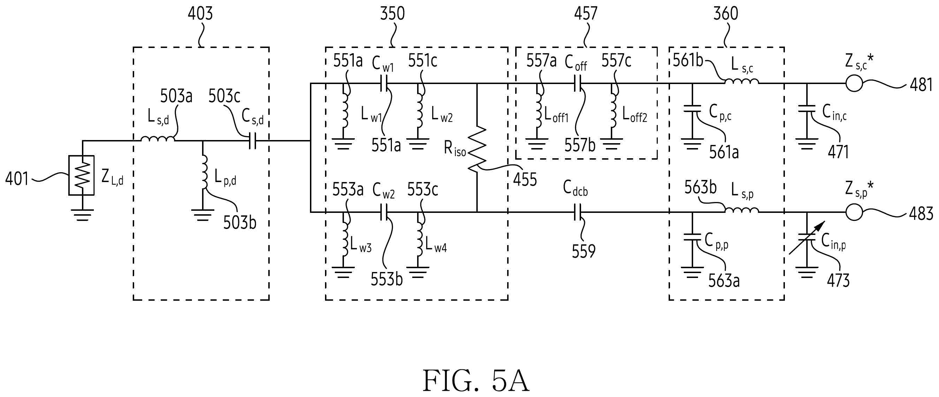

FIGS. 5A to 5C illustrate examples of a network circuit (e.g., the network circuit 340) of a dual stage Doherty power amplifier (e.g., the dual stage Doherty power amplifier 300). The network circuit 340 may be connected to an input stage 481 (Z_{s,c}*) of a carrier amplifier of a Doherty amplification circuit 370 and an input stage 483 (Z_{s,p}*) of a peaking amplifier of the Doherty amplification circuit 370. A capacitance (C_{inp, c}) of an input capacitor 471 of the carrier amplifier may be fixed, but a capacitance (C_{inp, p}) of an input capacitor 473 of the peaking amplifier may be variable according to a power level. The same reference numerals may indicate the same descriptions.

Referring to FIG. 5A, the network circuit 340 may include an output matching circuit 403 for a drive amplification circuit 310. The output matching circuit 403 may function as a band pass filter. For example, the output matching circuit 403 may include an inductor 503a (L_{s,d}), an inductor 503b (L_{p,d}), and a capacitor 503c (C_{s,d}). The inductor 503a and the capacitor 503c may be arranged in series, and the inductor 503b may be arranged in parallel. For example, the output matching circuit 403 may have a phase of substantially 0 degrees. The network circuit 340 may include an input matching circuit 360 for the Doherty amplification circuit 370. The input matching circuit 360 may include a first input matching circuit 461 for the carrier amplifier and a second input matching circuit 463 for the peaking amplifier. The input matching circuit 360 may function as a low-pass filter. For example, the first input matching circuit 461 may include a capacitor 561a (C_{p,c}) arranged in parallel and an inductor 561b (L_{s,c}) arranged in series. The second input matching circuit 463 may include a capacitor 563a (C_{p,p}) arranged in parallel and an inductor 563b (L_{s,p}) arranged in series. The input matching circuit 360 may have a phase of substantially 90 degrees. That is, the input matching circuit 360 may provide a phase shift of substantially 90 degrees with respect to an input signal.

The network circuit 340 may include a power distribution circuit 350. The power distribution circuit 350 may function as a high-pass filter. The power distribution circuit 350 may include a first line 451, a second line 453, and an isolation resistor 455 (Rᵢₛₒ). Each of the first line 451 and the second line 453 may include at least one lumped element to provide a phase difference of substantially 90 degrees. For example, the first line 451 may include an inductor 551a (L_{w1}), a capacitor 551b (C_{w1}), and an inductor 551c (L_{w2}) for an L-C-L structure. The second line 453 may include an inductor 553a (L_{w3}), a capacitor 553b (C_{w2}), and an inductor 553c (L_{w4}) for an L-C-L structure. The power distribution circuit 350 of the network circuit 340 may have a phase of substantially -90 degrees. That is, the power distribution circuit 350 may provide a phase shift of substantially -90 degrees with respect to an input signal. The network circuit 340 may have a phase of substantially 0 degrees through the output matching circuit 403, the power distribution circuit 350, and the input matching circuit 360.

The network circuit 340 may include an offset line 457 and a capacitor 559 (C_{dcb}). The input matching circuit 360 may include a first input matching circuit 461 for the carrier amplifier and a second input matching circuit 463 for the peaking amplifier. The offset line 457 may be configured to compensate for a phase difference between two paths of the first input matching circuit 461 and the second input matching circuit 463. For example, the offset line 457 may include at least one lumped element for phase compensation. The offset line 457 may function as a 'P' type high-pass filter. The offset line 457 may include an inductor 557a (L_{off1}), a capacitor 557b (C_{off}), and an inductor 557c (L_{off2}) for an L-C-L structure. In addition, the network circuit 340 may include a capacitor 559 for blocking (or preventing) direct current between the power distribution circuit 350 and the input matching circuit 360.

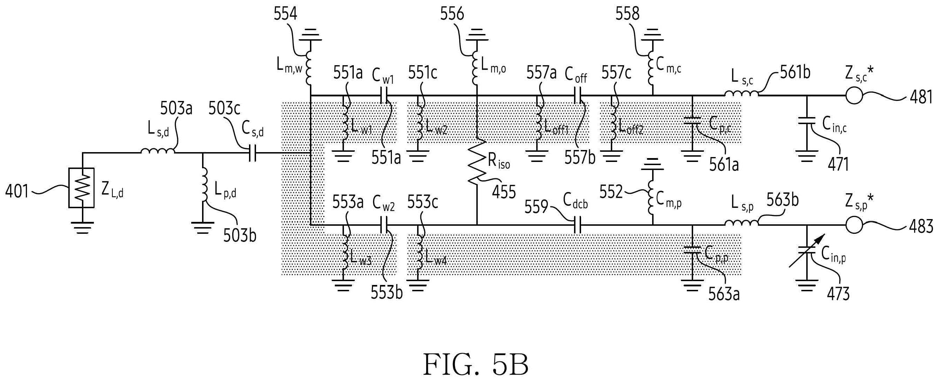

FIG. 5B is a diagram for describing simplification of the circuit structure of FIG. 5A. Referring to FIG. 5B, at least one passive element may be synthesized or omitted. For example, the inductor 551a and the inductor 553a arranged in parallel may be implemented as one inductor 554 (L_{m,w}). For example, the inductor 551c and the inductor 557a arranged in parallel may be implemented as one inductor 555 (L_{m,o}). For example, the inductor 557c and the capacitor 561a arranged in parallel may be implemented as one passive element (e.g., a capacitor 558 (C_{m,c})). As another example, according to an inductance of the inductor 557c and a capacitance magnitude of the capacitor 561a, it may be implemented as one inductor instead of the capacitor 558. For example, the inductor 553c and the capacitor 563a arranged in parallel may be implemented as one passive element (e.g., a capacitor 552 (C_{m,p})). As another example, according to an inductance of the inductor 553c and a capacitance magnitude of the capacitor 563a, it may be implemented as one inductor instead of the capacitor 552. In an operating frequency region, since it operates as a short circuit, a capacitor 559 (C_{dcb}) may not affect the synthesis of the inductor 553c and the capacitor 563a.

Through the parallel combination of elements, the number of elements for implementing the network circuit 340 of the dual stage Doherty power amplifier 300 may be reduced. In particular, when a plurality of inductors are synthesized into one inductor, the one inductor has a smaller inductance than individual parallel inductors, and thus not only a size of the element may be reduced, but also an insertion loss according to individual elements may be reduced. Therefore, through the circuit design illustrated in FIG. 5B, not only performance gain improvement due to loss reduction but also miniaturization of an amplification circuit may be achieved.

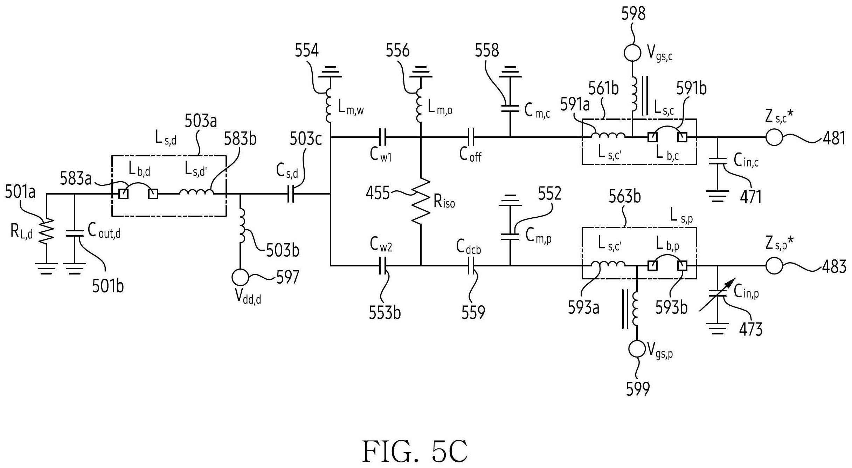

In FIG. 5C, an example of using the structure illustrated in FIG. 5B for an actual IC design is described. For example, values of elements of the Doherty power amplifier 300 may be determined in consideration of an arrangement according to an impedance of a bonding wire and a supply voltage (e.g., a drain voltage, a gate-source voltage).

For example, a drive load 401 (Z_{L,d}) for the drive amplification circuit 310 may include a resistor 501a (R_{L,d}) and a capacitor 501b (C_{out,d}) arranged in parallel.

For example, an output matching circuit 403 for the drive amplification circuit 310 may include an inductor 503a (L_{s,d}), an inductor 503b (L_{p,d}), and a capacitor 503c (C_{s,d}). In consideration of wire connection with a transistor of the drive amplification circuit 310, the inductor 503a (L_{s,d}) may be understood as including an inductor 583a (L_{b,d}) corresponding to a wire connected in series and an inductor 583b (Ls,d') for a design arrangement. In order to provide the inductor 503a, the output matching circuit 403 may include the inductor 583b having an inductance determined according to an inductance of the inductor 583a. Through the inductor 503b (L_{p,d}), a drain voltage 597 (V_{dd,d}) of the transistor of the drive amplification circuit 310 may be provided.

For example, in consideration of wire connection with a transistor of the carrier amplifier, an inductor 561b (L_{s,c}) may be understood as including an inductor 591b (L_{b,c}) corresponding to a wire connected in series and an inductor 591a (L_{s,c'}) for a design arrangement. In order to provide the inductor 591b, a first input matching circuit 461 may include the inductor 591a having an inductance determined according to an inductance of the inductor 591b. A gate-source voltage 598 (V_{gs,c}) for the transistor of the carrier amplifier may be applied to an input stage 481 (Z_{s,c}*) of the carrier amplifier through the inductor 561b. In consideration of wire connection with a transistor of the peaking amplifier, an inductor 563b (L_{s,p}) may be understood as including an inductor 593b (L_{b,p}) corresponding to a wire connected in series and an inductor 593a (L_{s,p***'***}) for a design arrangement. In order to provide the inductor 593b, a second input matching circuit 463 may include the inductor 591a having an inductance determined according to an inductance of the inductor 591b. A gate-source voltage 599 (V_{gs,p}) for the transistor of the peaking amplifier may be applied to an input stage 483 (Z_{s,p}) of the peaking amplifier through the inductor 563b.

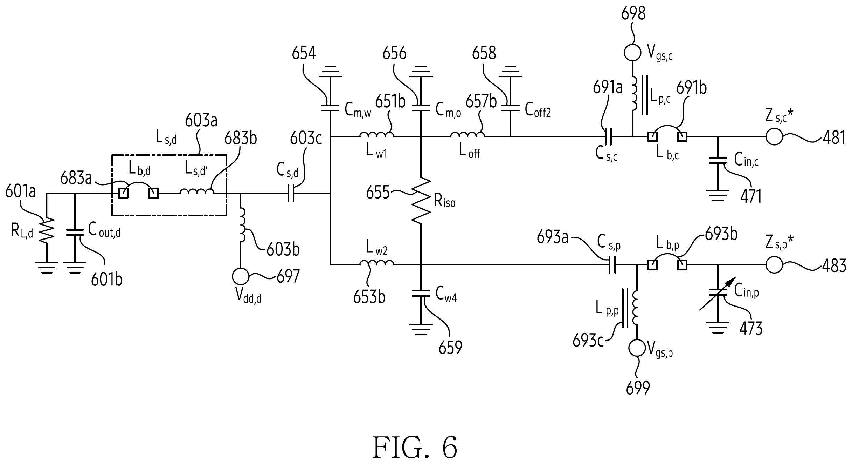

In FIGS. 5A to 5C, a circuit for matching a load impedance of the drive amplification circuit 310 to a characteristic impedance as the power distribution circuit 350 operates as a high-pass network having a phase of substantially 90 degrees and the input matching circuit 370 for the Doherty amplification circuit 370 operates as a low-pass network having a phase of substantially -90 degrees, has been described. However, embodiments of the present disclosure are not limited thereto. For example, the power distribution circuit 350 may operate as a low-pass network having a phase of substantially -90 degrees, and the input matching circuit 370 for the Doherty amplification circuit 370 may operate as a high-pass network having a phase of substantially 90 degrees. Hereinafter, an example of the network circuit 340 in which the power distribution circuit 350 operates as a low-pass network and the input matching circuit 370 operates as a high-pass network is described through FIG. 6.

FIG. 6 illustrates another example of a network circuit (e.g., the network circuit 340) of a dual stage Doherty power amplifier (e.g., the dual stage Doherty power amplifier 300).

Referring to FIG. 6, the network circuit 340 may include an output matching circuit 403 for a drive amplification circuit 310. The output matching circuit 403 may function as a band-pass filter. For example, the output matching circuit 403 may include an inductor 603a (L_{s,d}), an inductor 603b (L_{p,d}), and a capacitor 603c (C_{s,d}). The inductor 603a and the capacitor 603c may be arranged in series, and the inductor 603b may be arranged in parallel. For example, the output matching circuit 403 may have a phase of substantially 0 degrees. Through the inductor 603b (L_{p,d}), a drain voltage 697 (V_{dd,d}) of a transistor of the drive amplification circuit 310 may be provided.

The network circuit 340 may include an input matching circuit 360 for the Doherty amplification circuit 370. The input matching circuit 360 may include a first input matching circuit 461 for the carrier amplifier and a second input matching circuit 463 for the peaking amplifier. The input matching circuit 360 may function as a high-pass filter. For example, the first input matching circuit 461 may include a capacitor 691a (C_{p,c}) arranged in series, an inductor 691b (L_{b,c}) arranged in series, and an inductor 691c (L_{p,c}) arranged in parallel. The inductor 691b (L_{b,c}) may correspond to a bonding wire with a transistor of the carrier amplifier. A gate-source voltage 698 (V_{gs,c}) for the transistor of the carrier amplifier may be applied to an input stage 481 (Z_{s,c}*) of the carrier amplifier through an inductor 693b and an inductor 693c. The first input matching circuit 461 may have a phase of substantially -90 degrees. That is, the first input matching circuit 461 may provide a phase shift of substantially -90 degrees with respect to an input signal. The second input matching circuit 463 may include a capacitor 693a (C_{p,p}) arranged in series, an inductor 693b (L_{b,p}) arranged in series, and an inductor 693c (L_{p,p}) arranged in parallel. The inductor 693b (L_{b,p}) may correspond to a bonding wire with a transistor of the peaking amplifier. A gate-source voltage 699 (V_{gs,c}) for the transistor of the peaking amplifier may be applied to the input stage 481 (Z_{s,c}*) of the carrier amplifier through the inductor 693b and the inductor 693c. The second input matching circuit 463 may have a phase of substantially -90 degrees. That is, the second input matching circuit 463 may provide a phase shift of substantially -90 degrees with respect to an input signal.

The network circuit 340 may include a power distribution circuit 350 and an offset line 457. Since the input matching circuit 360 functions as a high-pass filter, the power distribution circuit 350 may function as a low-pass filter. The power distribution circuit 350 may include a first line 451, a second line 453, and an isolation resistor 455 (Rᵢₛₒ). Each of the first line 451 and the second line 453 may include at least one lumped element to provide a phase difference of substantially -90 degrees. For example, a circuit arrangement using synthesized elements illustrated through FIG. 5B may be used. As an example, the power distribution circuit 350 and the offset line 457 may include an inductor 651b (L_{w1}), an inductor 653b (L_{w2}), an inductor 657b (L_{wff}), a capacitor 654 (C_{m,w}), a capacitor 656 (C_{m,o}), a capacitor 658 (C_{off2}), a capacitor 659 (C_{w4}), and an isolation resistor 655. The power distribution circuit 350 of the network circuit 340 may have a phase of substantially 90 degrees. That is, the power distribution circuit 350 may provide a phase shift of substantially 90 degrees with respect to an input signal. The network circuit 340 may have a phase of substantially 0 degrees through the output matching circuit 403, the power distribution circuit 350, and the input matching circuit 360.

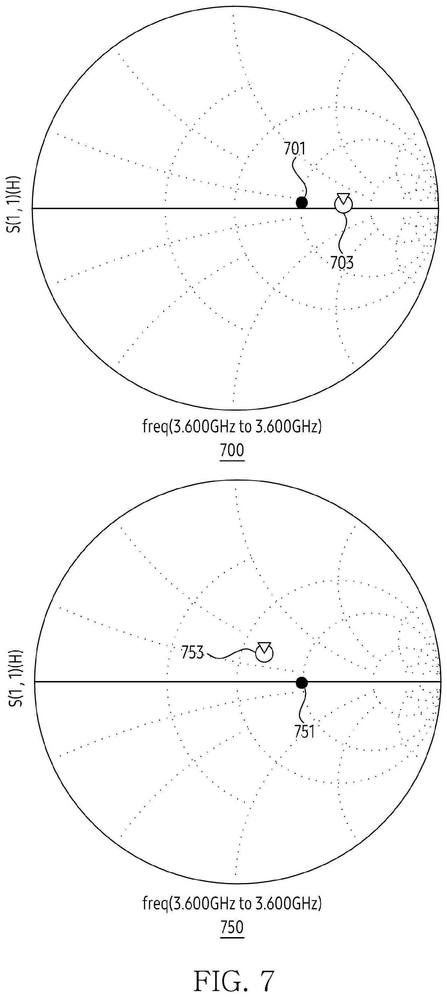

FIG. 7 illustrates examples of a smith chart of a dual stage Doherty power amplifier (e.g., the dual stage Doherty power amplifier 300).

Referring to FIG. 7, a smith chart 700 illustrates a load impedance of a drive amplification circuit 310 according to an output power of the dual stage Doherty power amplifier 300. In a situation where a peaking amplifier is turned on at a high output power, assume a situation where matching according to a capacitance (C_{in,p}) of an input capacitor 473 is performed. For example, the drive amplification circuit 310 may have a load impedance 701 of substantially 100 ohms. On the other hand, in a situation before the peaking amplifier is turned on (or a situation where it is turned off again) because the output power is low, assume a situation where the matching is not performed as the capacitance (C_{in,p}) of the input capacitor 473 decreases. For example, the drive amplification circuit 310 may have a load impedance 703 of substantially 165 ohms. Since an input matching circuit 360 provides a phase shift (hereinafter, phase alignment) in an opposite direction by a phase of a power distribution circuit 350, the load impedance viewed from the drive amplification circuit 310 may have a larger load at a low output power. Since a relatively small current flows due to the high load impedance, power consumption of the dual stage Doherty power amplifier 300 may be reduced. The network circuit 340 may enable appropriate load modulation of a drive amplifier through the phase shift without an additional circuit (e.g., an offset line for a drive amplification stage), thereby improving efficiency of the dual stage Doherty power amplifier 300.

A smith chart 750 illustrates a load impedance of a drive amplification stage in a legacy dual stage Doherty power amplifier in which phase alignment in the network circuit 340 is not performed. In the legacy dual stage Doherty power amplifier, an input of the carrier amplifier and an input of the peaking amplifier have a phase difference of substantially 90 degrees. Therefore, a network circuit between the drive amplification stage and a Doherty amplification stage of the legacy dual stage Doherty power amplifier may have a phase of substantially 90 degrees. In a situation where the peaking amplifier is turned on at a high output power, assume a situation where matching according to a capacitance (C_{in,p}) of the input capacitor 473 is performed. For example, the drive amplification stage may have a load impedance 751 of substantially 100 ohms. On the other hand, in a situation before the peaking amplifier is turned on (or a situation where it is turned off again) because the output power is low, assume a situation where the matching is not performed as the capacitance (751) of the input capacitor 473 decreases. For example, the drive amplification stage may have a load impedance 753 of substantially 63.8+j17.8 ohms. As an impedance of a magnitude smaller than substantially 100 ohms is provided, current consumption in the drive amplification stage may increase. Due to the high current consumption, power consumption of the legacy dual stage Doherty power amplifier may increase overall.

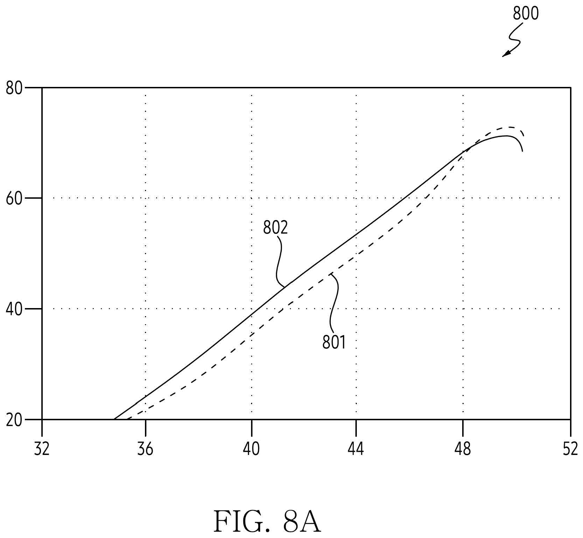

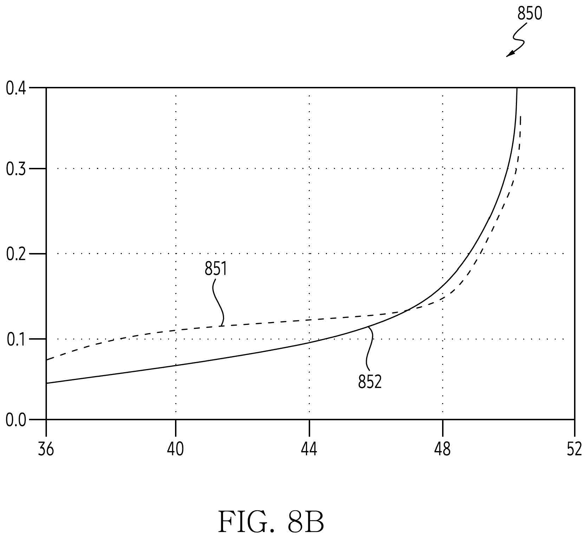

FIGS. 8A and 8B illustrate examples of performance of a dual stage Doherty power amplifier (e.g., the dual stage Doherty power amplifier 300).

Referring to FIG. 8A, a graph 800 illustrates efficiency with respect to power. A horizontal axis of the graph 800 illustrates power (unit: decibel milliwatt (dBm)), and a vertical axis of the graph 800 illustrates power added efficiency (PAE) (unit: percent (%)) of a power amplifier. A first line 801 illustrates efficiency of a legacy dual stage Doherty power amplifier (e.g., a power amplifier in which phase alignment between a power divider 350 and an input matching circuit 360 is not performed), and a second line 802 illustrates efficiency of the dual stage Doherty power amplifier 300 described through FIGS. 3 to 9. For example, assuming that an output power is substantially 50 dBm and a back-off power is substantially 8 dB, an input power may be substantially 42 dBm. At the input power, the first line 801 illustrates substantially 42.3%, and the second line 802 illustrates substantially 46%. Referring to the first line 801 and the second line 802, an improved efficiency of substantially 8.7% may be identified.

Referring to FIG. 8B, a graph 850 illustrates a current of a drive amplification circuit 310. A horizontal axis of the graph 850 illustrates power (unit: decibel milliwatt (dBm)), and a vertical axis of the graph 850 illustrates a current (unit: ampere (A)) of the drive amplification circuit 310. A first line 851 illustrates a current intensity of a drive amplification stage in a legacy dual stage Doherty power amplifier (e.g., a power amplifier in which phase alignment between the power divider 350 and the input matching circuit 360 is not performed). A second line 852 illustrates a current intensity of the drive amplification circuit 310 in the dual stage Doherty power amplifier 300 described through FIGS. 3 to 9. For example, assuming that an output power is substantially 50 dBm and a back-off power is substantially 8 dB, an input power may be substantially 42 dBm. At the input power, the first line 801 illustrates substantially 116 mA, and the second line 802 illustrates substantially 81 mA. Referring to the first line 851 and the second line 852, a current consumption reduced to a level of substantially 70% may be identified. The reduction in the current consumption may indicate a reduction in total power consumption of the dual stage Doherty power amplifier 300 as a whole.

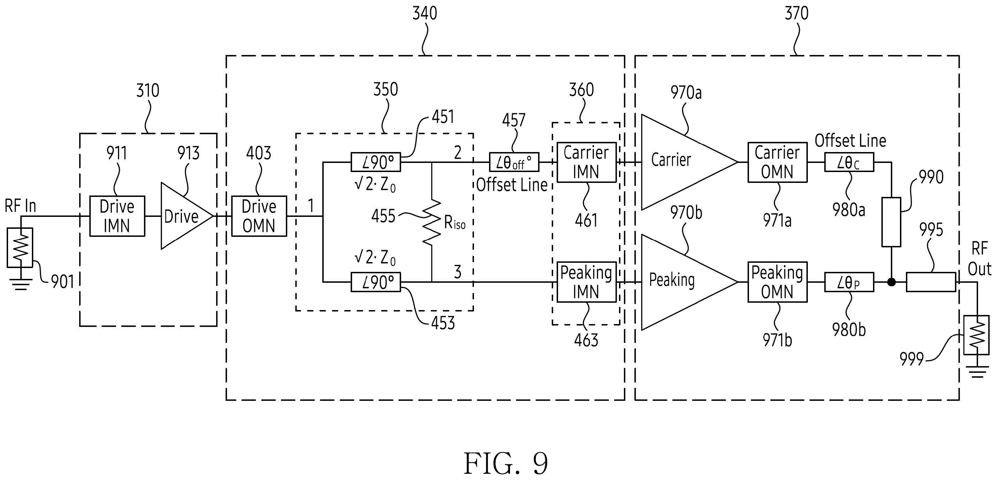

FIG. 9 illustrates examples of components of a dual stage Doherty power amplifier (e.g., the dual stage Doherty power amplifier 300).

Referring to FIG. 9, the dual stage Doherty power amplifier 300 may include a drive amplification circuit 310. For example, the drive amplification circuit 310 may include a drive amplifier 913 (e.g., a transistor) of the drive amplification circuit 310. For example, the drive amplification circuit 310 may include an input matching circuit 911 for impedance matching between a side where an RF signal is inputted (e.g., a load 901) and the drive amplifier 913.

The dual stage Doherty power amplifier 300 may include a network circuit 340. The structure exemplified in FIGS. 3 to 8B may be referred to as a description of the network circuit 340. The same reference numerals may be used for the same description.

The dual stage Doherty power amplifier 300 may include a Doherty amplification circuit 370. A first RF signal and a second RF signal distributed through a power distribution circuit 350 may pass through a first input matching circuit 461 and a second input matching circuit 463 and may be inputted to an input stage 481 and an input stage 483 of the Doherty amplification circuit 370, respectively. The input stage 481 may be connected to a carrier amplifier path of the Doherty amplification circuit 370. The carrier amplifier path may include a carrier amplifier 970a (e.g., a transistor, a FET), a first output matching network circuit 971a, a first offset line 980a, and a transmission line 990. The first offset line 980a may be used to compensate for and optimize a parasitic component inside the carrier amplifier 970a. The Doherty amplification circuit 370 may include an impedance transformer for load modulation after the first output matching network circuit 971a. For example, the impedance transformer may include the transmission line 990. The transmission line 990 may have a λ/4 length of substantially 50 ohms. λ may represent a wavelength of a frequency of a signal. The input stage 483 may be connected to a peaking amplifier path of the Doherty amplification circuit 370. The peaking amplifier path may include a peaking amplifier 970b, a second output matching network circuit 971b, and a second offset line 980b. The second offset line 980b may be used to compensate for and optimize a parasitic component inside the peaking amplifier 970b.

A first RF signal passed through the carrier amplifier path and a second RF signal passed through the peaking amplifier path may be combined. The dual stage Doherty power amplifier 300 may include an impedance transformer 950 for impedance matching of the combined signal. A combining stage 393 may be connected to an impedance transformer for matching with an external reference impedance 999 (e.g., substantially 50 ohms, an external antenna).

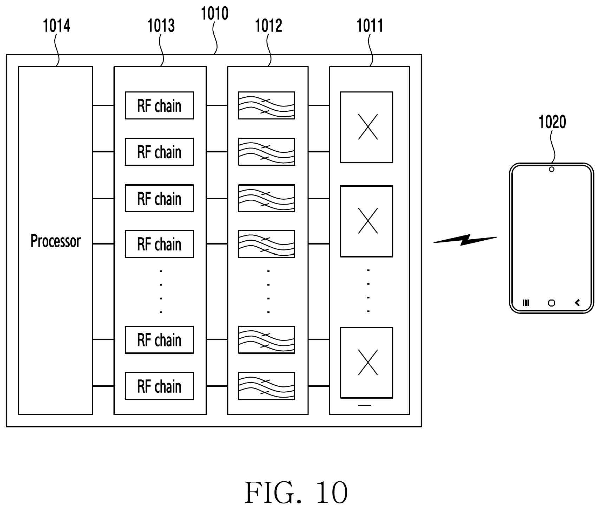

FIG. 10 illustrates an example of components of an electronic device. For example, an electronic device 1010 is one of the base station 110 (or the RU 220) and the terminal 120, and an electronic device 1020 may be another one of the base station 110 (or the RU 220) and the terminal 120. The electronic device 1010 may be antenna equipment of an RFIC including one or more RF chains. In addition to the power amplifier (e.g., the dual stage Doherty power amplifier 300) itself described through FIGS. 3 to 9, an electronic device including the power amplifier is also included in the embodiments of the present disclosure. The electronic device 1010 may include a network circuit 340 in which phase alignment (e.g., providing a phase difference of substantially 0 degrees through phase shift between a power distribution circuit 350 and an input matching circuit 360) is performed to increase a load impedance of a drive amplification stage of the dual stage Doherty power amplifier 300 at a low output power.

Referring to FIG. 10, an exemplary functional configuration of an electronic device 1010 is illustrated. The electronic device 1010 may include an antenna unit 1011, a filter unit 1012, a radio frequency (RF) processing unit 1013, and a control unit 1014.

The antenna unit 1011 may include a plurality of antennas. An antenna performs functions for transmitting and receiving a signal through a wireless channel. The antenna may include a radiator formed of a conductor or a conductive pattern formed on a substrate (e.g., a PCB). The antenna may radiate an up-converted signal on the wireless channel or obtain a signal radiated by another device. Each antenna may be referred to as an antenna element or an antenna device. According to an embodiment, the antenna unit 1011 may include an antenna array in which a plurality of antenna elements form an array. The antenna unit 1011 may be electrically connected to the filter unit 1012 through RF signal lines. The antenna unit 1011 may be mounted on a PCB including a plurality of antenna elements. The PCB may include a plurality of RF signal lines connecting each antenna element and a filter of the filter unit 1012. Such RF signal lines may be referred to as a feeding network. The antenna unit 1011 may provide a received signal to the filter unit 1012 or radiate a signal provided from the filter unit 1012 into the air.

The filter unit 1012 may perform filtering to transfer a signal of a desired frequency. The filter unit 1012 may perform a function for selectively identifying a frequency by forming resonance. The filter unit 1012 may include at least one of a band pass filter, a low pass filter, a high pass filter, or a band reject filter. That is, the filter unit 1012 may include RF circuits for obtaining a signal of a frequency band for transmission or a frequency band for reception. The filter unit 1012 according to various embodiments may electrically connect the antenna unit 1011 and the RF processing unit 1013.

The RF processing unit 1013 may include a plurality of RF paths. The RF path may be a unit of a path through which a signal received through the antenna or a signal radiated through the antenna passes. At least one RF path may be referred to as an RF chain. The RF chain may include a plurality of RF elements. The RF elements may include an amplifier, a mixer, an oscillator, a digital-to-analog converter (DAC), an analog-to-digital converter (ADC), and the like. For example, the RF processing unit 1013 may include an up converter configured to up-convert a digital transmission signal of a base band into a transmission frequency, and a DAC configured to convert the up-converted digital transmission signal into an analog RF transmission signal. The up converter and the DAC form a part of a transmission path. The transmission path may further include a power amplifier (PA) or a coupler (or a combiner). In addition, for example, the RF processing unit 1013 may include an ADC configured to convert an analog RF reception signal into a digital reception signal, and a down converter configured to convert a digital reception signal into a digital reception signal of the base band. The ADC and the down converter form a part of a reception path. The reception path may further include a low-power amplifier (low-noise amplifier (LNA)) or a coupler (or a divider). The RF components of the RF processing unit may be implemented on the PCB. For example, a base station 1010 may include a structure stacked in an order of the antenna unit 1011, the filter unit 1012, and the RF processing unit 1013. For example, the antennas and the RF components of the RF processing unit may be implemented on the PCB. For example, filters may be repeatedly fastened between the PCB and the PCB and form a plurality of layers.

The RF processing unit 1013 may include a plurality of RF processing chains for a plurality of signal paths transferred to the antenna unit 111 and the filter unit 1012. For example, the RF processing unit 1013 may be an RFIC. The RFIC may include the plurality of RF processing chains. A signal applied in a baseband may be inputted to the RFIC. The signal inputted to the RFIC may be distributed to each antenna element. At this time, an independent phase shift may be applied to each of the antenna elements for beamforming. Therefore, the RFIC may include RF processing chains for processing of a signal to be transferred to each antenna element. Each RF processing chain may include one or more RF components for RF signal processing. The RF processing unit 1013 may include a drive amplification circuit 310, a network circuit 340, and a Doherty amplification circuit 370. For example, the network circuit 340 may include a power distribution circuit 350 having a phase of substantially 90 degrees and an input matching circuit 360 having a phase of substantially -90 degrees. As another example, the network circuit 340 may include a power distribution circuit 350 having a phase of substantially 090 degrees and an input matching circuit 360 having a phase of substantially 90 degrees.

The control unit 1014 may control overall operations of the electronic device 1010. The control unit 1014 may include various modules for performing communication. The control unit 1014 may include at least one processor such as a modem. The control unit 1014 may include modules for digital signal processing. For example, the control unit 1014 may include the modem. When transmitting data, the control unit 1014 generates complex symbols by encoding and modulating a transmission bit stream. In addition, for example, when receiving data, the control unit 1014 restores a reception bit stream through demodulation and decoding of a baseband signal. The control unit 1014 may perform functions of a protocol stack required by a communication standard.

In FIG. 10, a functional configuration of the electronic device 1010 has been described as equipment in which the Doherty power amplifier of the present disclosure may be utilized. However, the example illustrated in FIG. 10 is only an example configuration for the utilization of the Doherty power amplifier described through FIGS. 1 to 9, and embodiments of the present disclosure are not limited to components illustrated in FIG. 10. An RF module including the above-described Doherty power amplifier having a resistance selection circuit, an MMIC, a PAM, an RFIC, communication equipment of another configuration, or a structure for the Doherty power amplifier may also be understood as embodiments of the present disclosure.

The Doherty power amplifier according to the embodiments of the present disclosure may include a dual stage Doherty power amplifier configured in dual stage. In the dual stage Doherty power amplifier, by configuring an electrical length of a drive amplification stage to be substantially 0 degrees, efficiency of the drive amplification stage may be increased at a low output power (e.g., a second state in which a peaking amplifier of the Doherty amplification circuit does not operate). Generally, in a maximum output situation (e.g., a first state in which a peaking amplifier of the Doherty amplification circuit operates), impedance matching is performed. In order to reduce a high current consumption that may occur due to impedance mismatch, the dual stage Doherty power amplifier according to the embodiments of the present disclosure may use a phase design in a network circuit at the low output power (e.g., the second state in which the peaking amplifier of the Doherty amplification circuit does not operate). Rather than inserting a separate offset line in a drive amplification circuit, elements of a network circuit 340 may be arranged such that a phase of a power distribution circuit 350 of the network circuit (e.g., the network circuit 340) and a phase of an input matching circuit 360 cancel each other out in opposite directions. Through the elements of the network circuit 340, without a separate additional circuit, efficiency of the power amplifier is increased, and implementation in a form such as an IC is facilitated. Through design of a matching network circuit (e.g., an input matching network circuit, an output matching network circuit) and the power distribution circuit 350 included in the network circuit 340, a load impedance in the drive amplification circuit is appropriately modulated from low output to high output, and current consumption may be improved.

In embodiments, a dual stage Doherty power amplifier 300 is provided. The dual stage Doherty power amplifier 300 may include a drive amplification circuit 310, a Doherty amplification circuit 370 including a carrier amplifier and a peaking amplifier, and a network circuit 340 disposed between the drive amplification circuit 310 and the Doherty amplification circuit 370. The network circuit 340 may include an output matching circuit 403 for the drive amplification circuit 310, a power distribution circuit 350 for distributing an output of the drive amplification circuit 310 to each of the carrier amplifier and the peaking amplifier, a first input matching circuit 461 for the carrier amplifier, and a second input matching circuit 463 for the peaking amplifier. The power distribution circuit 350 may be configured to provide a phase difference of a specified magnitude in a first direction. Each of the first input matching circuit 461 and the second input matching circuit 463 may be configured to provide a phase difference of the specified magnitude in a second direction opposite to the first direction.

According to an embodiment, the power distribution circuit 350 may include a first transmission line for the carrier amplifier, a second transmission line for the peaking amplifier, and a resistor connected to the first transmission line and the second transmission line.

According to an embodiment, the first transmission line may be configured to provide a phase difference of a specified magnitude in the first direction. The second transmission line may be configured to provide a phase difference of a specified magnitude in the first direction.

According to an embodiment, the power distribution circuit 350 may correspond to a high pass circuit for providing a phase difference of substantially -90 degrees. The first input matching circuit 461 may correspond to a low pass circuit for providing a phase difference of substantially 90 degrees. The second input matching circuit 463 may correspond to a low pass circuit for providing a phase difference of substantially 90 degrees.

According to an embodiment, the first input matching circuit 461 may include a first capacitor arranged in parallel and a first inductor arranged in series. The second input matching circuit 463 may include a second capacitor arranged in parallel and a second inductor arranged in series.

According to an embodiment, each transmission line of the power distribution circuit 350 may include a third inductor arranged in parallel, a fourth inductor arranged in parallel, and a third capacitor connected in series between the third inductor and the fourth inductor, in an L-C-L structure.

According to an embodiment, the power distribution circuit 350 may correspond to a low pass circuit for providing a phase difference of substantially 90 degrees. The first input matching circuit 461 may correspond to a high pass circuit for providing a phase difference of substantially -90 degrees. The second input matching circuit 463 may correspond to a high pass circuit for providing a phase difference of substantially -90 degrees.

According to an embodiment, the first input matching circuit 461 may include a first capacitor arranged in series and a first inductor arranged in parallel. The second input matching circuit 463 may include a second capacitor arranged in series and a second inductor arranged in parallel.

According to an embodiment, each transmission line of the power distribution circuit 350 may include a third capacitor arranged in parallel, a fourth capacitor arranged in parallel, and a third inductor connected in series between the third capacitor and the fourth capacitor, in a C-L-C structure.

According to an embodiment, the network circuit 340 may include an offset line and a capacitor disposed between the power distribution circuit 350 and the input matching circuit. The offset line may be used for phase conversion of an input signal to at least one of the carrier amplifier or the peaking amplifier. The capacitor may be used to prevent a direct current between the power distribution circuit 350 and the input matching circuit.

According to an embodiment, a gate-source voltage of a first transistor of the carrier amplifier may be provided through an inductor of the first input matching circuit 461. A gate-source voltage of a second transistor of the peaking amplifier may be provided through an inductor of the second input matching circuit 463.

According to an embodiment, the output matching circuit 403 may correspond to a band pass circuit for providing a phase of substantially 0 degrees. The output matching circuit 403 may include a first inductor arranged in series, a capacitor arranged in series, and a second inductor arranged in parallel between the first inductor and the capacitor. A drain voltage of a transistor of the drive power amplification circuit may be provided through the first inductor and the second inductor.

According to an embodiment, an input impedance from the drive amplification circuit 310 to the network circuit 340 may correspond to a first value in a first state in which only the carrier amplifier among the carrier amplifier and the peaking amplifier of the Doherty amplification circuit 370 operates. An input impedance from the drive amplification circuit 310 to the network circuit 340 may correspond to a second value smaller than the first value, in a second state in which both the carrier amplifier and the peaking amplifier of the Doherty amplification circuit 370 operate.

According to an embodiment, the output matching circuit 403, the network circuit 340, and the input matching circuit may be configured to provide impedance matching of the Doherty amplification circuit 370 in the second state in which both the carrier amplifier and the peaking amplifier of the Doherty amplification circuit 370 operate.

According to an embodiment, a first inductor of the first input matching circuit 461 may be associated with a bonding wire connected to a transistor of the carrier amplifier. A second inductor of the second input matching circuit 463 may be associated with a bonding wire connected to a transistor of the peaking amplifier.

In embodiments, an electronic device including a dual stage Doherty power amplifier 300 is provided. The electronic device may include a plurality of antennas, a plurality of filters for the plurality of antennas, a plurality of RF processing circuits for the plurality of antennas, and a processor. Each RF processing circuit of the plurality of RF processing circuits may include the dual stage Doherty power amplifier 300. The dual stage Doherty power amplifier 300 may include a drive amplification circuit 310, a Doherty amplification circuit 370 including a carrier amplifier and a peaking amplifier, and a network circuit 340 disposed between the drive amplification circuit 310 and the Doherty amplification circuit 370. The network circuit 340 may include an output matching circuit 403 for the drive amplification circuit 310, a power distribution circuit 350 for distributing an output of the drive amplification circuit 310 to each of the carrier amplifier and the peaking amplifier, a first input matching circuit 461 for the carrier amplifier, and a second input matching circuit 463 for the peaking amplifier. The power distribution circuit 350 may be configured to provide a phase difference of a specified magnitude in a first direction. Each of the first input matching circuit 461 and the second input matching circuit 463 may be configured to provide a phase difference of the specified magnitude in a second direction opposite to the first direction.

According to an embodiment, the power distribution circuit 350 may correspond to a high pass circuit for providing a phase difference of substantially -90 degrees. The first input matching circuit 461 may correspond to a low pass circuit for providing a phase difference of substantially 90 degrees. The second input matching circuit 463 may correspond to a low pass circuit for providing a phase difference of substantially 90 degrees.

According to an embodiment, the power distribution circuit 350 may correspond to a low pass circuit for providing a phase difference of substantially 90 degrees. The first input matching circuit 461 may correspond to a high pass circuit for providing a phase difference of substantially -90 degrees. The second input matching circuit 463 may correspond to a high pass circuit for providing a phase difference of substantially -90 degrees.

According to an embodiment, an input impedance from the drive amplification circuit 310 to the network circuit 340 may correspond to a first value in a first state in which only the carrier amplifier among the carrier amplifier and the peaking amplifier of the Doherty amplification circuit 370 operates. An input impedance from the drive amplification circuit 310 to the network circuit 340 may correspond to a second value smaller than the first value, in a second state in which both the carrier amplifier and the peaking amplifier of the Doherty amplification circuit 370 operate.

According to an embodiment, the dual stage Doherty power amplifier 300 may be included in a power amplifier module (PAM) in each RF processing circuit.

RF power amplifiers, which require a substantial heat dissipation system because they use the most power in a wireless communication system, account for high cost and volume. An inter-stage structure of a dual stage Doherty power amplifier has a problem in which efficiency of load modulation of a drive amplifier decreases at a low output (e.g., an inactive state of a peaking amplifier of a Doherty amplifier). The network circuit 340 of the dual stage Doherty power amplifier 300 according to the embodiments of the present disclosure may provide improved efficiency through appropriate load modulation of the drive amplification circuit 310 at the low output section. In addition, as illustrated through FIG. 5B, through synthesis of inductors and/or capacitors of the network circuit 340, and through optimization of an internal circuit structure (e.g., minimizing the number of components, reducing a size of an inductor), a circuit of the dual stage Doherty power amplifier 300 suitable for miniaturization and weight reduction may be designed. By improving the overall efficiency of the dual stage Doherty power amplifier 300 without the burden of additional circuits (e.g., an offset line of a drive amplification stage) of FIGS. 7, 8A, and 8B, power consumption may be reduced, and through this, a heat dissipation system of an electronic device may also be simplified.

The effects that can be obtained from the present disclosure are not limited to those described above, and any other effects not mentioned herein will be clearly understood by those having ordinary knowledge in the art to which the present disclosure belongs, from the following description.

For one or more embodiments, at least one of components described in one or more of the preceding drawings may be configured to perform one or more operations, techniques, processes, and/or methods as described in the present disclosure. For example, a processor (e.g., a baseband processor) described in the present disclosure in association with one or more of the preceding drawings may be configured to operate according to one or more examples described in the present disclosure. For another example, a circuit associated with user equipment (UE), a base station, a network element, or the like, as described above in association with one or more of the preceding drawings, may be configured to operate according to one or more examples described herein.

Any of the embodiments described above may be combined with any other embodiment (or a combination of embodiments) unless explicitly stated otherwise. The foregoing description of one or more implementations is provided for illustration and explanation, but is not intended to limit the scope of the embodiments or to be exhaustive to the precise forms disclosed. Modifications and variations are possible in light of the above teachings or may be obtained from practice of various embodiments.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

Methods according to embodiments described in claims or specifications of the present disclosure may be implemented as a form of hardware, software, or a combination of hardware and software.

In a case of implementing as software, a computer-readable storage medium for storing one or more programs (software module) may be provided. The one or more programs stored in the computer-readable storage medium are configured for execution by one or more processors in an electronic device. The one or more programs include instructions that cause the electronic device to execute the methods according to embodiments described in claims or specifications of the present disclosure. The one or more programs may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. In the case of being distributed online, at least part of the computer program product may be temporarily generated or at least temporarily stored in the machine-readable storage medium, such as memory of the manufacturer's server, the application store's server, or a relay server.

Such a program (software module, software) may be stored in a random access memory, a non-volatile memory including a flash memory, a read only memory (ROM), an electrically erasable programmable read only memory (EEPROM), a magnetic disc storage device, an optical storage device (e.g., a compact disc-ROM (CD-ROM), digital versatile discs (DVDs), or other formats), or a magnetic cassette. Alternatively, it may be stored in memory configured with a combination of some or all of them. In addition, a plurality of configuration memories may be included.

Additionally, a program may be stored in an attachable storage device that may be accessed through a communication network such as the Internet, Intranet, local area network (LAN), wide area network (WAN), or storage area network (SAN), or a combination thereof. Such a storage device may be connected to a device performing an embodiment of the present disclosure through an external port. In addition, a separate storage device on the communication network may also be connected to a device performing an embodiment of the present disclosure.

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be executed sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

## Claims

1. A dual stage doherty power amplifier, comprising:
a drive amplification circuit;
a doherty amplification circuit including a carrier amplifier and a peaking amplifier; and
a network circuit disposed between the drive amplification circuit and the doherty amplification circuit,
wherein the network circuit includes:
an output matching circuit for the drive amplifier circuit,
a power distribution circuit for distributing the output of the drive amplifier circuit to each of the carrier amplifier and the peaking amplifier,
a first input matching circuit for the carrier amplifier, and
a second input matching circuit for the peaking amplifier,
wherein the power distribution circuit is configured to provide a phase difference of a specified magnitude in a first direction, and
wherein each of the first input matching circuit and the second input matching circuit is configured to provide a phase difference of the specified magnitude in a second direction opposite to the first direction.

2. The dual stage doherty power amplifier of claim 1,
wherein the power distribution circuit includes a first transmission line for the carrier amplifier, a second transmission line for the peaking amplifier, and a resistor connected to the first transmission line and the second transmission line.

3. The dual stage doherty power amplifier of claim 2,
wherein the first transmission line is configured to provide a phase difference of a specified magnitude in the first direction, and
wherein the second transmission line is configured to provide a phase difference of a specified magnitude in the first direction.

4. The dual stage doherty power amplifier of claim 1,
wherein the power distribution circuit corresponds to a high-pass circuit to provide a phase difference being -90 degrees substantially,
wherein the first input matching circuit corresponds to a low-pass circuit to provide a phase difference being 90 degrees substantially, and
wherein the second input matching circuit corresponds to a low-pass circuit to provide a phase difference being 90 degrees substantially.

5. The dual stage doherty power amplifier of claim 4,
wherein the first input matching circuit includes a first capacitor arranged in parallel and a first inductor arranged in series, and
wherein the second input matching circuit includes a second capacitor arranged in parallel and a second inductor arranged in series.

6. The dual stage doherty power amplifier of claim 5, wherein each transmission line of the power distribution circuit includes a third inductor arranged in parallel, a fourth inductor arranged in parallel, and a third capacitor connected in series between the third inductor and the fourth inductor, in an L-C-L structure.

7. The dual stage doherty power amplifier of claim 1,
wherein the power distribution circuit corresponds to a low-pass circuit to provide a phase difference being 90 degrees substantially,
wherein the first input matching circuit corresponds to a high-pass circuit to provide a phase difference being -90 degrees substantially, and
wherein the second input matching circuit corresponds to a high-pass circuit to provide a phase difference being -90 degrees substantially.

8. The dual stage doherty power amplifier of claim 7,
wherein the first input matching circuit includes a first capacitor arranged in series and a first inductor arranged in parallel, and
wherein the second input matching circuit includes a second capacitor arranged in series and a second inductor arranged in parallel.

9. The dual stage doherty power amplifier of claim 8, wherein each transmission line of the power distribution circuit includes a third capacitor arranged in parallel, a fourth capacitor arranged in parallel, and a third inductor connected in series between the third capacitor and the fourth capacitor, in a C-L-C structure.

10. The dual stage doherty power amplifier of claim 1,
wherein the network circuit includes an offset line and a capacitor disposed between the power distribution circuit and the input matching circuit,
wherein the offset line is used for phase conversion of an input signal to at least one of the carrier amplifier or the peaking amplifier, and
wherein the capacitor is used to prevent direct current between the power distribution circuit and the input matching circuit.

11. The dual stage doherty power amplifier of claim 1,
wherein a gate-source voltage of a first transistor of the carrier amplifier is provided through an inductor of the first input matching circuit, and
wherein a gate-source voltage of a second transistor of the peaking amplifier is provided through an inductor of the second input matching circuit,

12. The dual stage doherty power amplifier of claim 1,
wherein the output matching circuit corresponds to a bandpass circuit to provide a phase being 0 degrees substantially,
wherein the output matching circuit includes a first inductor arranged in series, a capacitor arranged in series, and a second inductor arranged in parallel between the first inductor and the capacitor, and
wherein a drain voltage of a transistor of the drive power amplification circuit is provided through the first inductor and the second inductor.

13. The dual stage doherty power amplifier of claim 1, wherein an input impedance from the drive amplifier circuit to the network circuit corresponds to:
a first value in a first state in which only the carrier amplifier among the carrier amplifier and the peaking amplifier of the doherty amplification circuit operates, and
a second value smaller than the first value, in a second state in which both the carrier amplifier and the peaking amplifier of the doherty amplification circuit operate.

14. The dual stage doherty power amplifier of claim 1, wherein the output matching circuit, the network circuit, and the input matching circuit are configured to provide impedance matching of the doherty amplification circuit in a second state in which both the carrier amplifier and the peaking amplifier of the doherty amplification circuit operate.

15. An electronic device including a dual stage doherty power amplifier, comprising:
a plurality of antennas;
a plurality of filters for the plurality of antennas;
a plurality of radio frequency (RF) processing circuits for the plurality of antennas; and
a processor,
wherein each RF processing circuit of the plurality of RF processing circuits includes the dual stage doherty power amplifier,
wherein the dual stage doherty power amplifier includes:
a drive amplification circuit,
a doherty amplification circuit including a carrier amplifier and a peaking amplifier, and
a network circuit disposed between the drive amplification circuit and the doherty amplification circuit,
wherein the network circuit includes:
an output matching circuit for the drive amplifier circuit,
a power distribution circuit for distributing the output of the drive amplifier circuit to each of the carrier amplifier and the peaking amplifier,
a first input matching circuit for the carrier amplifier, and
a second input matching circuit for the peaking amplifier,
wherein the power distribution circuit is configured to provide a phase difference of a specified magnitude in a first direction, and
wherein each of the first input matching circuit and the second input matching circuit is configured to provide a phase difference of the specified magnitude in a second direction opposite to the first direction.
